# EUROPEAN PATENT APPLICATION

(11) **EP 4 694 600 A1**
(43) Date of publication of application: **11.02.2026**
(21) Application number: 24815942.8
(22) Date of filing: 03.06.2024
(51) Int. Cl.: H05K 7/20, G02B 27/01

(54) **HEAT DISSIPATION STRUCTURE AND ELECTRONIC DEVICE COMPRISING SAME**

(30) Priority: 02.06.2023 KR 20230071406; 16.10.2023 KR 20230138009
(71) Applicant: Samsung Electronics Co., Ltd., Suwon-si, Gyeonggi-do 16677 (KR)
(72) Inventor: YOON, Youngho, Suwon-si Gyeonggi-do 16677 (KR); JUNG, Sangchul, Suwon-si Gyeonggi-do 16677 (KR)
(74) Representative: Nederlandsch Octrooibureau
(86) International application number: PCT/KR2024/007581
(87) International publication number: WO 2024/248568

(57) **Abstract**

A head-mounted display device, according to one embodiment of the present disclosure, may comprise: a housing; a printed circuit board positioned inside the housing and including a heat source; at least one display positioned inside the housing; at least one display plate supporting the display; and at least one fan structure inducing convection so as to discharge heat generated inside the head-mounted display device to the outside of the head-mounted display device, and including a plurality of outlets. The plurality of outlets may include: a first outlet disposed adjacent to the printed circuit board and configured to dissipate heat generated by the heat source; and a second outlet in contact with a portion of the display plate, and configured to dissipate heat that has been generated by the display and transferred to the display plate. Various other embodiments are possible.

## Description

### [Technical Field]

An embodiment disclosed herein relates to a heat dissipation structure and an electronic device including the same.

### [Background Art]

Due to the remarkable development of information communication technology and semiconductor technology, the distribution and use of various electronic devices are rapidly increasing. In particular, recent electronic devices are being developed such that users are capable of communicating with each other while carrying the electronic devices.

The electronic devices may mean devices that perform a specific function according to a program provided therein (e.g., an electronic scheduler, a portable multimedia reproducer, a mobile communication terminal, a tablet PC, an image/sound device, a desktop/laptop PC, or a vehicle navigation system), as well as home appliances. For example, these electronic devices may output information stored therein as sound or an image. With the increase of degree of integration of electronic devices and the generalization of ultra-high-speed and high-capacity wireless communication, recently, various functions are capable of being installed in a single electronic device, such as a mobile communication terminal. For example, in addition to communication functions, entertainment functions such as games, multimedia functions such as music/video playback, communication and security functions for mobile banking, and functions such as schedule management or electronic wallet, are being integrated into a single electronic device. These electronic devices are being miniaturized to be conveniently carried by users.

The foregoing information may be provided as related art for the purpose of helping understanding of the disclosure. No claim or determination is made as to whether any of the foregoing may be applied as a prior art related to the disclosure.

### [Detailed Description of the Invention]

### [Technical Solution]

A head-mounted display device according to an embodiment of the disclosure may include a housing, a printed circuit board located inside the housing and including at least one heat source, at least one display located inside the housing, at least one display plate configured to support the display, and at least one fan structure comprising a fan and multiple outlets and configured to guide heat generated inside the head-mounted display device to be discharged to the outside of the head-mounted display device. The multiple outlets may include a first outlet disposed adjacent to the printed circuit board and configured to dissipate heat generated from the heat source, and a second outlet disposed in contact with a portion of the display plate and configured to dissipate heat generated from the display and transferred to the display plate.

An electronic device according to an embodiment of the disclosure may include a housing, a printed circuit board located inside the housing and including at least one heat source, at least one display located inside the housing, at least one display plate configured to support the display, and at least one fan structure comprising a fan and multiple outlets and configured to induce convection so that heat generated inside the electronic device can be discharged to the outside of the electronic device. The multiple outlets may include a first outlet disposed adjacent to the printed circuit board and configured to dissipate heat generated from the heat source, and a second outlet disposed in contact with a portion of the display plate and configured to dissipate heat generated from the display and transferred to the display plate. The multiple outlets may include at least one pillar.

### [Brief Description of Drawings]

The above and other aspects, features and advantages of certain embodiments of the present disclosure will be more apparent from the following detailed description, take in conjunction with the accompanying drawings, in which:
FIG. 1 is a block diagram of an electronic device according to an embodiment disclosed herein in a network environment.
FIG. 2 is a perspective view of a wearable electronic device according to an embodiment disclosed herein.
FIG. 3 is a perspective view illustrating an internal configuration of a wearable electronic device according to an embodiment disclosed herein.
FIG. 4 is an exploded perspective view of a wearable electronic device according to an embodiment disclosed herein.
FIG. 5 is a view illustrating the inside of an electronic device according to an embodiment disclosed herein.
FIGS. 6A and 6B are perspective views illustrating some of the internal components of an electronic device according to an embodiment disclosed herein, viewed from the front side.
FIGS. 7A, 7B and 7C are perspective views illustrating some of the internal components of an electronic device according to an embodiment disclosed herein, viewed from the rear side.
FIGS. 8A, 8B, and 8C are views illustrating a display plate according to various embodiments disclosed herein.
FIG. 9 is a side view illustrating some of the internal components of the electronic device according to an embodiment disclosed herein, viewed in the X-axis direction.
FIG. 10 is a view illustrating a fan structure according to an embodiment disclosed herein.
FIGS. 11A, 11B, 11C, 11D, 11E, and 11F are views illustrating the coupling relationship between a fan structure and a display plate according to an embodiment disclosed herein.
FIGS. 12A, 12B, and 12C are views illustrating a fan structure including multiple pillars according to an embodiment disclosed herein.
FIG. 13 is a view illustrating an electronic device including a small fan structure according to an embodiment disclosed herein.
FIG. 14A is a view illustrating the front side of a wearable electronic device according to an embodiment of the disclosure.
FIG. 14B is a view illustrating the rear side of a wearable electronic device according to an embodiment of the disclosure.

### [Mode for Carrying out the Invention]

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

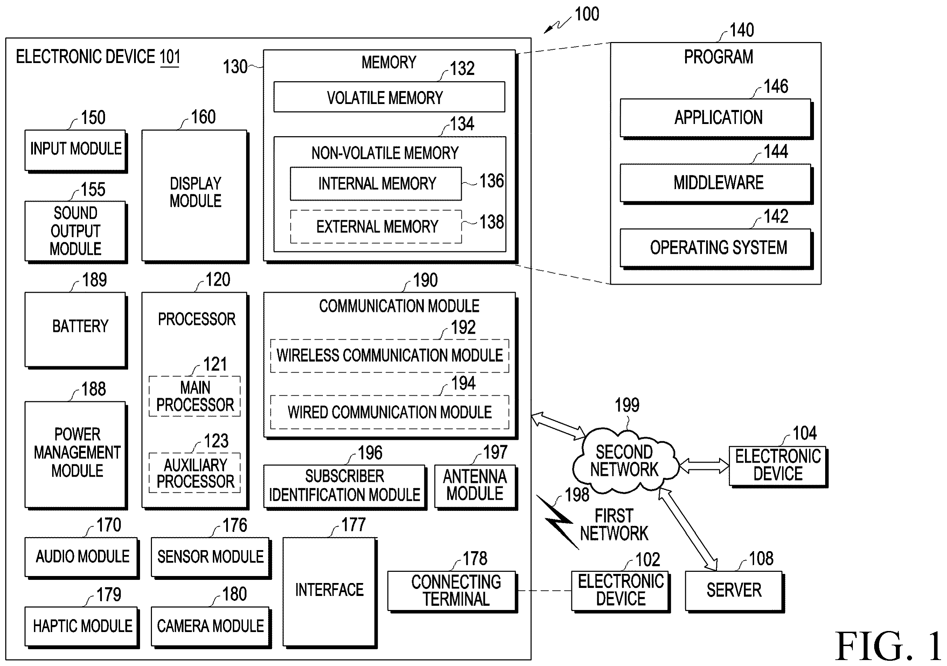

FIG. 1 is a block diagram illustrating an electronic device 101 in a network environment 100 according to this disclosure.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

According to an embodiment, each external electronic device (e.g., the electronic device 102, the electronic device 104, or the server 108) may be the same or a different type of device from the electronic device 101. According to an embodiment, all or some of the operations performed on the electronic device 101 may be executed using one or more of the external electronic devices (e.g., the electronic device 102, the electronic device 104, or the server 108). For example, when the electronic device 101 is to perform a certain function or service automatically, or in response to a request from a user or another device, the electronic device 101 may request one or more external electronic devices to perform at least a part of the function or the service, instead or in addition to executing the function or service by itself. The one or more external electronic devices that receive the request may execute at least a part of the requested function or service, or an additional function or service associated with the request, and may deliver the result of the execution to the electronic device 101. The electronic device 101 may provide the result, either as is or after further processing, at least a part of a response to the request. For example, an external electronic device (e.g., the electronic device 102, the electronic device 104, or the server 108) may transmit content data executed by an application to the electronic device 101 after rendering, and the electronic device 101 which receives the data may output the content data to a display module. When the electronic device 101 detects the user's motion via an IMU sensor or the like, the processor of the electronic device 101 may correct the rendering data received from the external electronic device (e.g., the electronic device 102, the electronic device 104, or the server 108) based on information on the motion and may output the corrected rendering data to the display module. The information on the motion may be transmitted to an external electronic device (e.g., the electronic device 102, the electronic device 104, or the server 108) to request rendering so that screen data is updated accordingly. According to an embodiment, the external electronic device (e.g., the electronic device 102, the electronic device 104, or the server 108) may be various types of devices such as a smartphone or a case device capable of storing and charging the electronic device 101.

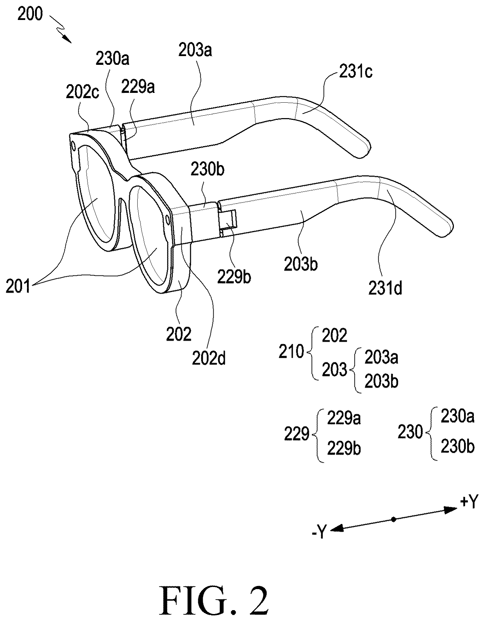

FIG. 2 is a perspective view of a wearable electronic device 200 according to an embodiment disclosed herein.

Referring to FIG. 2, the wearable electronic device 200 is a glasses-type electronic device (e.g., the electronic device 101 in FIG. 1), and a user may visually recognize a surrounding object or environment in the state of wearing the wearable electronic device 200. For example, the wearable electronic device 200 may include a head-mounted device (HMD) or smartglasses capable of providing an image directly in front of the user's eyes. All or some of the components of the wearable electronic device 200 of FIG. 2 may be the same as those of the electronic device 101 of FIG. 1.

According to an embodiment, the wearable electronic device 200 may include a housing 210 that defines the external appearance of the wearable electronic device 200. The housing 210 may provide a space in which components of the wearable electronic device 200 may be disposed. For example, the housing 210 may include a lens frame 202 and at least one wearing member 203.

According to an embodiment, the wearable electronic device 200 may include one or more display members 201 disposed inside the housing 210 and capable of outputting a visual image. For example, the wearable electronic device 200 may include one or more display members 201 capable of providing visual information (or images) to the user. For example, the display members 201 may include a lens, a display, a waveguide, and/or a module equipped with a touch circuit. According to an embodiment, the display members 201 may be transparent or translucent. According to an embodiment, the display members 201 may include glass made of a translucent material or a window member having a light transmittance that is adjustable as the color concentration thereof is adjusted.

According to an embodiment, the lens frame 202 may accommodate at least a portion of the display members 201. For example, the lens frame 202 may surround at least a portion of the edge of the display members 201. According to an embodiment, the lens frame 202 may position at least one of the display members 201 to correspond to a user's eye. According to an embodiment, the lens frame 202 may be a rim of a general eyeglasses structure. According to an embodiment, the lens frame 202 may include at least one closed curve surrounding the display members 201. According to an embodiment, the lens frame 202 may include a first end 202c and a second end 202d opposite to the first end 202c. The first end 202c may be disposed adjacent to a first wearing member 203a, and the second end 202d may be disposed adjacent to a second wearing member 203b.

According to an embodiment, the wearing members 203 may extend from the lens frame 202. For example, the wearing members 203 may each extend from an end of the lens frame 202 and may be supported or positioned on the user's body (e.g., the ears), together with the lens frame 202. According to an embodiment, the wearing members 203 may each be rotatably coupled to the lens frame 202 via a hinge structure 229. According to an embodiment, the wearing members 203 may each include an inner surface 231c configured to face the user's body and an outer surface 231d opposite to the inner surface 231c. According to an embodiment (not illustrated), the wearing members 203 may be at least partially made of a flexible material (e.g., rubber). For example, the wearing members 203 may have a band shape surrounding at least a portion of the user's body (e.g., the ears).

According to an embodiment, the wearable electronic device 200 may include hinge structures 229 configured to enable the wearing members 203 to be folded relative to the lens frame 202. The hinge structures 229 may be disposed between the lens frame 202 and the wearing members 203. In the state in which the wearable electronic device 200 is not worn, the user may carry or store the wearable electronic device 200 in the state in which the wearing members 203 are folded to partially overlap the lens frame 202. According to an embodiment, the hinge structures 229 may include a first hinge structure 229a connected to a portion of the lens frame 202 (e.g., the first end 202c) and the first wearing member 203a and a second hinge structure 229b connected to a portion of the lens frame 202 (e.g., the second end 202d) and the second wearing member 203b.

According to an embodiment, the first hinge structure 229a and the second hinge structure 229b may be disposed to be spaced apart from the display member 201 by a predetermined distance in the Y-axis direction. Hinge connection structures 230 may include a first hinge connection structure 230a and a second hinge connection structure 230b. The first hinge structure 229a may be fixed to the lens frame 202 by the first hinge connection structure 230a, and the second hinge structure 229b may be fixed to the lens frame 202 by the second hinge connection structure 230b.

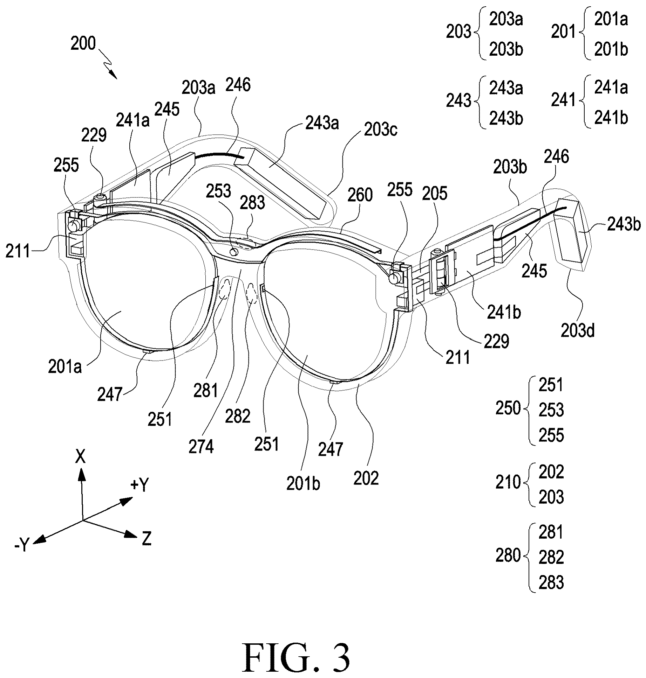

FIG. 3 is a perspective view illustrating the internal configuration of a wearable electronic device 200 according to an embodiment disclosed herein in an assembled state.

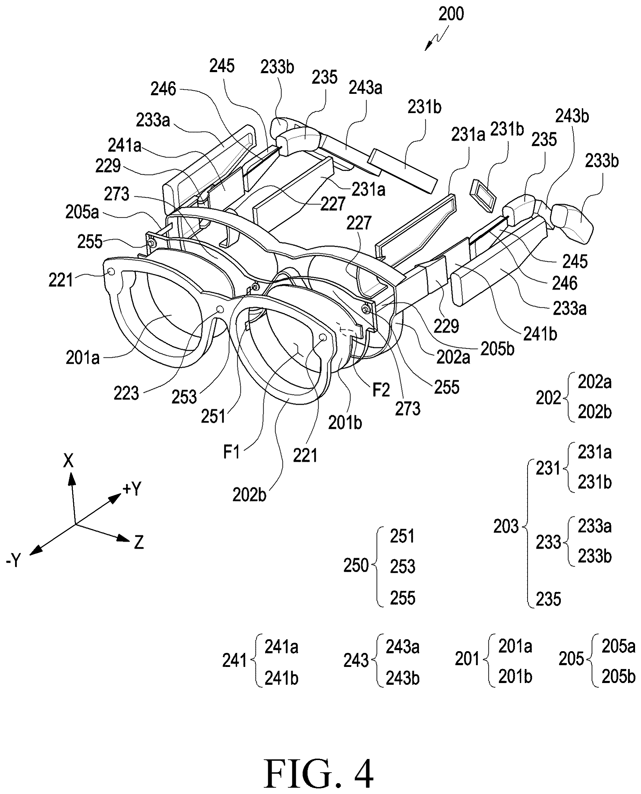

FIG. 4 is an exploded perspective view of the wearable electronic device 200 according to an embodiment disclosed herein.

The configurations of the display members 201, the lens frame 202, the wearing members 203, and the hinge structures 229 of FIG. 3 and/or FIG. 4 may wholly or partially the same as those of the display members 201, the lens frame 202, the wearing members 203, and the hinge structures 229 of FIG. 2.

Referring to FIGS. 3 and 4, the wearable electronic device 200 may include one or more display members 201, a lens frame 202, one or more wearing members 203, one or more hinge structures 229, one or more circuit boards 241, one or more batteries 243, one or more power transmission structures 246, one or more camera modules 250, and/or one or more sensor modules 280.

According to an embodiment, the wearable electronic device 200 may acquire and/or recognize visual images regarding an object or environment in a direction, in which the user gazes or the wearable electronic device 200 is directed (e.g., the -Y direction) by using the camera modules 250 (e.g., the camera module 180 in FIG. 1), and may receive information about the object or environment from an external electronic device (e.g., the electronic device 102 or 104 in FIG. 1 or the server 108 of FIG. 1) via a network (e.g., the first network 198 or the second network 199 in FIG. 1). In an embodiment, the wearable electronic device 200 may provide the user with the received information about the object or environment in an acoustic or visual form. The wearable electronic device 200 may provide the user with the received information about the object or environment via the display members 201 in a visual form by using a display module (e.g., the display module 160 in FIG. 1). For example, the wearable electronic device 200 may implement augmented reality by implementing the information about object or environment in a visual form and combining the information implemented in the visual form with an actual image of the environment around the user.

According to an embodiment, the display members 201 may be provided as a pair and disposed corresponding to the user's left and light eyes, respectively, in the state in which the wearable electronic device 200 is worn on the user's body. For example, the display members 201 may include a first display member 201a and a second display member 201b disposed to be spaced apart from the first display member 201a. The first display member 201a may be disposed corresponding to the user's right eye, and the second display member 201b may be disposed corresponding to the user's left eye.

According to an embodiment, the display members 201 may each include a first surface F1 oriented in a direction in which external light is incident (e.g., in the -Y direction) and a second surface F2 oriented in a direction opposite to the direction in which the first surface F1 is oriented (e.g., in the +Y direction). In the state in which the user wears the wearable electronic device 200, at least a part of the light or image incident through the first surface F1 may pass through the second surfaces F2 of the display members 201, which are disposed to face the user's left eye and/or right eye to be incident to the user's left eye and/or right eye.

According to an embodiment, the lens frame 202 may include at least two or more frames. For example, the lens frame 202 may include a first frame 202a and a second frame 202b. According to an embodiment, when the user wears the wearable electronic device 200, the first frame 202a may be a frame of a portion facing the user's face, and the second frame 202b may be a portion of the lens frame 202 spaced apart from the first frame 202a in the user's gazing direction (e.g., the -Y direction).

According to an embodiment, the wearable electronic device 200 may include one or more light output modules 211 configured to provide an image and/or a video to the user. For example, the light output modules 211 may include display panels (not illustrated) capable of outputting an image, and lenses (not illustrated) corresponding to the user's eyes and configured to guide the image to the display members 201. For example, the user may acquire an image output from the display panels of the light output modules 211 through the lenses of the light output modules 211. According to various embodiments, the light output modules 211 may each include a device configured to display various information. For example, the light output modules 211 may each include at least one of a liquid crystal display (LCD), a digital mirror device (DMD), a liquid crystal-on-silicon (LCoS), a light-emitting diode (LED)-on-silicon (LEDoS), an organic light-emitting diode (OLED), or a micro light-emitting diode (micro LED). According to an embodiment, when the light output modules 211 and/or the display members 201 each include one of the liquid crystal display device, the digital mirror display device, or the liquid crystal-on-silicon (LCoS) display device, the wearable electronic device 200 may include light sources configured to emit light to the display areas of the light output modules 211 and/or the display members 201. According to an embodiment, when the light output modules 211 and/or the display members 201 each include one of the organic light emitting diode or the micro-LED, the wearable electronic device 200 may provide a virtual image to the user without including a separate light source.

According to an embodiment, the light output modules 211 may be at least partially disposed inside the housing 210. For example, the light output modules 211 may be connected to the display members 201, respectively, and may provide an image to the user via the display members 201. For example, an image output from the light output modules 211 is incident on the display members 201 via input optical members (not illustrated) located at one ends of the display members 201, and may be emitted to the user's eyes through waveguides (not illustrated) and output optical members (not illustrated) each of which is located in at least a portion of corresponding one of the display members 201.

According to an embodiment of the disclosure, the display members 201 may each include an optical waveguide (e.g., a waveguide). According to an embodiment of the disclosure, the output image of the light output modules 211 incident on one ends of the optical waveguides may be propagated within the optical waveguides and provided to the user. According to an embodiment of the disclosure, the optical waveguides may each include at least one of a diffractive optical element (DOE), a holographic optical element (HOE), or a reflective element (e.g., a reflective mirror). For example, the optical waveguides may guide the image output from the light output modules 211 to the user's eyes by each including at least one of the diffractive optical element, the holographic optical element, or the reflective element (e.g., a reflective mirror).

According to an embodiment, the wearable electronic device 200 may include circuit boards 241 each of which accommodates components for driving the wearable electronic device 200 (e.g., a printed circuit board (PCB), a printed board assembly (PBA), an FPCB (flexible PCB), or a rigid-flexible PCB (RFPCB)). For example, the circuit boards 241 may each include at least one integrated circuit chip, and at least one of a processor (not illustrated) (e.g., the processor 120 in FIG. 1), memory (not illustrated) (e.g., the memory 130 in FIG. 1), a power management module (not illustrated) (e.g., the power management module 188 in FIG. 1), or a communication module (e.g., the communication module 190 in FIG. 1) may be provided in the integrated circuit chip. According to an embodiment, the circuit boards 241 may be disposed in the wearing members 203 of the housing 210. For example, the circuit boards 241 may include a first circuit board 241a disposed within the first wearing member 203a and a second circuit board 241b disposed within the second wearing member 203b. According to an embodiment, a communication module (e.g., the communication module 190 in FIG. 1) may be disposed on the first circuit board 241a located within the first wearing member 203a, and a processor (e.g., the processor 120 in FIG. 1) may be disposed on the second circuit board 241b located within the second wearing member 203b. According to an embodiment, the circuit boards 241 may be electrically connected to batteries 243 (e.g., the battery 189 in FIG. 1) via the power transmission structures 246, respectively. According to an embodiment, the circuit boards 241 may each include an interposer board.

According to an embodiment, the batteries 243 may be electrically connected to the components (e.g., the light output modules 211, the circuit boards 241, the speaker modules 245, the microphone modules 247, and/or the camera modules 250) of the wearable electronic device 200, and may supply power to the components of the wearable electronic device 200.

According to an embodiment, the batteries 243 may be at least partially disposed within the wearing members 203, respectively. According to an embodiment, the batteries 243 may include a first battery 243a disposed within the first wearing member 203a and a second battery 243b disposed within the second wearing member 203b. According to an embodiment, the batteries 243 may be disposed adjacent to the ends 203c and 203d of the wearing members 203, respectively.

According to an embodiment, the speaker modules 245 (e.g., the audio module 170 or the sound output module 155 in FIG. 1) may convert an electrical signal into sound. The speaker modules 245 may be at least partially disposed in the wearing members 203 of the housing 210. According to an embodiment, the speaker modules 245 may be located in the wearing members 203 to correspond to the user's ears. According to an embodiment (e.g., FIG. 3), the speaker modules 245 may be disposed next to the circuit boards 241, respectively. For example, the speaker modules 245 may be disposed between the circuit boards 241 and the batteries 243, respectively. According to an embodiment (not illustrated), the speaker modules 245 may be disposed on the circuit boards 241, respectively. For example, the speaker modules 245 may be disposed between the circuit boards 241 and the inner cases (e.g., the inner cases 231 in FIG. 4), respectively.

According to an embodiment, the wearable electronic device 200 may include power transmission structures 246 configured to transmit power of the batteries 243 to electronic components (e.g., the light output modules 211) of the wearable electronic device 200. For example, the power transmission structures 246 may be electrically connected to the batteries 243 and/or the circuit boards 241, and the circuit boards 241 may transmit, to the light output modules 211, power received via the power transmission structures 246. According to an embodiment, the power transmission structures 246 may have a configuration capable of transmitting power. For example, the power transmission structures 246 may each include a flexible printed circuit board or a wire. For example, the wire may include a plurality of cables (not illustrated). In various embodiments, the shape of the power transmission structures 246 may be variously modified in consideration of the number and/or type of cables.

According to an embodiment, the microphone modules 247 (e.g., the input module 150 and/or the audio module 170 in FIG. 1) may convert sound into an electrical signal. According to an embodiment, the microphone modules 247 may be placed within the lens frame 202. For example, at least one microphone modules 247 may be disposed at a lower end (e.g., in the -X-axis direction) and/or at an upper end (e.g., in the +X-axis direction) of the wearable electronic device 200. According to an embodiment, the wearable electronic device 200 may more clearly recognize the user's voice by using voice information (e.g., sound) acquired from the one or more microphone modules 247. For example, the wearable electronic device 200 may distinguish voice information from ambient noise based on acquired voice information and/or additional information (e.g., low-frequency vibration of the user's skin and bone). For example, the wearable electronic device 200 may clearly recognize the user's voice and may perform a function of reducing ambient noise (e.g., noise canceling).

According to an embodiment, the camera modules 250 may capture a still image and/or a video image. The camera modules 250 may each include at least one of a lens, at least one image sensor, an image signal processor, or a flash. According to an embodiment, the camera modules 250 may be disposed in the lens frame 202 and around the display members 201.

According to an embodiment, the camera modules 250 may each include at least one first camera module 251. According to an embodiment, the first camera module 251 may photograph the trace of the user's eye (e.g., pupil) or gaze. For example, the first camera module 251 may include a light-emitting unit (e.g., an IR LED) (not illustrated) configured to emit light in an infrared band, and a camera structure (not illustrated) configured to image a reflection pattern of the light emitted by the light emitting unit to the user's eye. According to an embodiment, in order to make a virtual image projected to the display members 201 correspond to the direction in which the user's pupils gaze, the processor (e.g., the processor 120 in FIG. 1) may adjust the position of the virtual image. According to an embodiment, the traces of the user's eyes or gaze may be tracked by using a plurality of first camera modules 251 having the same standard and performance.

According to an embodiment, the camera modules 250 may each include a second camera module 253. According to an embodiment, the second camera module 253 may capture an external image. According to an embodiment, the second camera module 253 may capture an external image through a second optical hole 223 provided in the second frame 202b. For example, the second camera module 253 may include a high-resolution color camera, and may be a high-resolution (HR) or photo video (PV) camera. According to an embodiment, the second camera module 253 may provide an auto focus (AF) function and an optical image stabilizer (OIS) function.

According to an embodiment (not illustrated), the wearable electronic device 200 may include a flash (not illustrated) located adjacent to the second camera module 253. For example, the flash (not illustrated) may provide light for increasing the brightness (e.g., illuminance) around the wearable electronic device 200 when acquiring an external image of the second camera module 253, and may reduce difficulty of acquiring an image due to a dark environment, mixing of various light sources, and/or reflection of light.

According to an embodiment, the camera modules 250 may each include at least one third camera module 255. According to an embodiment, the third camera module 255 may photograph the user's motion through a first optical hole 221 provided in the lens frame 202. For example, the third camera module 255 may photograph the user's gesture (e.g., hand motion). The third camera modules 255 and/or first optical holes 221 may be disposed respectively at the opposite ends of the lens frame 202 (e.g., the second frame 202b) (e.g., the opposite ends of the lens frame 202 (e.g., the second frame 202b) in the Z direction). According to an embodiment, the third camera module 255 may include a global shutter (GS)-type camera. For example, the third camera module 255 may provide 360-degree spatial (e.g., omnidirectional) positional recognition and/or movement recognition with a camera supporting 3 degrees of freedom (3DoF) or 6DoF. According to an embodiment, the third camera module 255 may perform simultaneous localization and mapping (SLAM) and user gesture recognition by using a plurality of global shutter-type cameras having the same standard and performance as stereo cameras. According to an embodiment, the third camera module 255 may include an infrared (IR) camera (e.g., a time of flight (TOF) camera or a structured light camera). For example, the IR camera may be operated as at least a portion of a sensor module (e.g., the sensor module 176 in FIG. 1) configured to detect a distance to a subject.

According to an embodiment, at least one of the first camera modules 251 and the third camera modules 255 may be replaced with a sensor module (e.g., the sensor module 176 in FIG. 1). For example, the sensor module may include at least one of a vertical cavity surface emitting laser (VCSEL), an infrared sensor, and/or a photodiode. For example, the photodiode may include a positive intrinsic negative (PIN) photodiode or an avalanche photodiode (APD). The photodiode may be interpreted as a photo detector or a photo sensor.

According to an embodiment, at least one of the first camera modules 251, the second camera modules 253, or the third camera modules 255 may include a plurality of camera modules (not illustrated). For example, the second camera modules 253 may each include a plurality of lenses (e.g., wide-angle and telephoto lenses) and image sensors, and may be disposed on one surface (e.g., the surface oriented in the -Y-axis direction) of the wearable electronic device 200. For example, the wearable electronic device 200 may include a plurality of camera modules having different attributes (e.g., angles of view) or functions, respectively, and may control the camera modules to change the angles of view thereof based on the user's selection and/or trace information. For example, at least one of the plurality of camera modules may be a wide-angle camera, and at least another one of the camera modules may be a telephoto camera.

According to an embodiment, the processor (e.g., the processor 120 in FIG. 1) may determine the movement of the wearable electronic device 200 and/or the user's gesture by using the information of the wearable electronic device 200 acquired by using at least one of the gesture sensor, the gyro sensor, or the acceleration sensor of the sensor module (e.g., the sensor module 176 in FIG. 1) and the user's motion (e.g., the approach of the user's body to the wearable electronic device 200) acquired by using the third camera module 255. According to an embodiment, in addition to the above-described sensors, the wearable electronic device 200 may include a magnetic (geomagnetic) sensor capable of measuring an azimuth by using a magnetic field and a line of magnetic force and/or a Hall sensor capable of acquiring movement information (e.g., a movement direction or a movement distance) by using the intensity of the magnetic field. For example, the processor may determine the movement of the wearable electronic device 200 and/or the movement of the user based on information acquired from the magnetic (geomagnetic) sensor and/or the Hall sensor.

According to an embodiment (not illustrated), the wearable electronic device 200 may perform an input function (e.g., a touch and/or a pressure detection function) capable of interacting with the user. For example, components configured to perform a touch and/or pressure detection function (e.g., a touch sensor and/or a pressure sensor) may be disposed on at least a portion of the wearing members 203. The wearable electronic device 200 may control a virtual image output through the display members 201 based on the information acquired via the components. For example, the sensors related to a touch and/or pressure detection function may be configured in various types, such as a resistive type, a capacitive type, an electro-magnetic (EM) type, or an optical type. According to an embodiment, all or some of the components configured to perform a touch detection function and/or a pressure detection function may be the same as those of the input module 150 of FIG. 1.

According to an embodiment, the wearable electronic device 200 may include a reinforcing member 260 disposed in the inner space of the lens frame 202 and configured to have a higher rigidity than that of the lens frame 202.

According to an embodiment, the wearable electronic device 200 may include lens structures 273. The lens structures 273 may refract at least a portion of light. For example, the lens structures 273 may be prescription lenses having a specified refractive power. According to an embodiment, the lens structures 273 may be at least partially disposed behind the display members 201 (e.g., in the +Y direction). For example, the lens structures 273 may be located between the display members 201 and the user's eyes.

According to an embodiment, the housing 210 may include hinge covers 227 capable of concealing portions of the hinge structures 229, respectively. The other portions of the hinge structures 229 may be accommodated or concealed between inner covers 231 and outer covers 233, which will be described later.

According to an embodiment, the wearing members 203 may each include an inner cover 231 and an outer cover 233. For example, the inner covers 231 are configured to face or come into direct contact with the user's body, and may be made of a material with low thermal conductivity such as a synthetic resin. According to an embodiment, the inner covers 231 may each include an inner side surface (e.g., the inner side surface 231c in FIG. 2) facing the user's body. For example, the outer covers 233 may each include at least partially a material capable of transmitting heat (e.g., a metal material) and may be coupled to face the inner covers 231. According to an embodiment, the outer cover 233 may each include an outer surface (e.g., the outer surface 231d in FIG. 2) that is opposite to the inner surface 231c. In an embodiment, at least one of the circuit boards 241 or the speaker modules 245 may be accommodated in a space separated from the battery 243 within the wearing member 203. In the illustrated embodiment, the inner covers 231 may include a first cover 231a accommodating the circuit board 241 and/or the speaker module 245 and a second cover 231b accommodating the battery 243, and the outer covers 233 may include a third cover 233a coupled to face the first cover 231a and a fourth cover 233b coupled to face the second cover 231b. For example, the first cover 231a and the third cover 233a (hereinafter, "first cover units 231a and 233a") may be coupled to accommodate the circuit board 241 and/or the speaker module 245, and the second cover 231b and the fourth cover 233b (hereinafter, "second cover units 231b and 233b") may be coupled to accommodate the battery 243.

According to an embodiment, the first cover units 231a and 233a may be rotatably coupled to the lens frame 202 via the hinge structures 229, and the second cover units 231b and 233b may be connected to or mounted on the ends of the first cover units 231a and 233a via the connection structures 235. According to an embodiment, the portions of the connection structures 235 that come into contact with the user's body may be made of a material having a low thermal conductivity (e.g., an elastic material such as silicone, polyurethane, or rubber), and the portions that do not come into contact with the user's body may be made of a material having a high thermal conductivity (e.g., a metal material). For example, when heat is generated from the circuit boards 241 or the batteries 243, the connection structures 235 block heat from being transferred to portions that come into contact with the user's body, and may dissipate or release heat through the portions that do not come into contact with the user's body. According to an embodiment, the portions of the connection members 235 that are implemented to come into contact with the user's body may be interpreted as portions of the inner covers 231, and the portions of the connection members 235 that do not come into contact with the user's body may be interpreted as portions of the outer covers 233. According to an embodiment (not illustrated), each first cover 231a and each second cover 231b may be integrally configured without a connection structure 235, and each third covers 233a and each fourth case 233b may be integrally configured without a connection structure 235. According to an embodiment, in addition to the illustrated components, other components (e.g., the antenna module 197 in FIG. 1) may be further included, and information about an object or environment may be received from an external electronic device (e.g., the electronic device 102 or 104 in FIG. 1 or the server 108 in FIG. 1) by using a communication module (e.g., the communication module 190 in FIG. 1) via a network (e.g., the first network 198 or the second network 199 in FIG. 1).

According to an embodiment, the lens frame 202 may include a connection portion 274 between the first display member 201a and the second display member 201b. For example, the connection portion 274 may be interpreted as a portion corresponding to the nose pads of glasses.

According to an embodiment, the wearable electronic device 200 may include connection members 205. According to an embodiment, the circuit boards 241 may be connected to the connection members 205, respectively, and may transmit electrical signals to the components (e.g., the light output modules 211 and/or the camera modules 250) of the wearable electronic device 200 via the connection members 205. For example, a control signal transmitted from a processor (e.g., the processor 120 of FIG. 1) located on the circuit board 241 may be transmitted to electronic components by using at least a portion of the connection members 205. For example, at least a portion of the connection members 205 may include wires (not illustrated) electrically connected to components of the wearable electronic device 200.

According to an embodiment, the connection members 205 may include a first connection member 205a at least partially disposed in the first wearing member 203a and a second connection member 205b at least partially disposed in the second wearing member 203b. According to an embodiment, the first connection member 321 and/or the second connection member 322 may at least partially face the hinge structures 229. For example, the first connection member 205a may extend from the first circuit board 241a to the inside of the lens frame 202 across the hinge structure 229. The second connection member 205b may extend from the second circuit board 241b to the inside of the lens frame 202 across the hinge structure 229. For example, a portion of the first connection member 205a and a portion of the second connection member 205b may be disposed within the wearing members 203, and the other portions may be disposed within the lens frame 202.

According to an embodiment, the first connection member 321 and the second connection member 322 may include structures that are foldable or unfoldable based on the rotation of the hinge structures 229, respectively. For example, the first connection member 205a and/or the second connection member 205b may include a flexible printed circuit board (FPCB). According to an embodiment, the first connection member 205a may be electrically and/or mechanically connected to the first circuit board 241a. According to an embodiment, the second connection member 205b may be electrically and/or mechanically connected to the second circuit board 241b. According to an embodiment, the first connection member 205a and/or the second connection member 205b may include structures (e.g., wires and/or cables) for transmitting signals.

According to an embodiment, the sensor modules 280 (e.g., the sensor module 176 in FIG. 1) may detect light passing through the display members 201. According to an embodiment, the sensor modules 280 may include a first sensor module 281 capable of detecting light passing through the first display member 201a, and a second sensor module 282 capable of detecting light passing through the second display member 201b. For example, the first sensor module 281 may detect light at the rear side (e.g., the +Y direction) of the first display member 201a, and the second sensor module 282 may detect light at the rear side of the second display member 201b. According to an embodiment, the sensor modules 280 may include a third sensor module 283 capable of detecting light at the front side (e.g., the -Y direction) of the display members 201. For example, the third sensor module 283 may detect light at the front side (e.g., the -Y direction) of the display members 201. According to an embodiment, the sensor modules 280 may be illuminance sensors. According to an embodiment, the configuration of the third sensor module 283 may be partially or wholly the same as that of the second camera module 253.

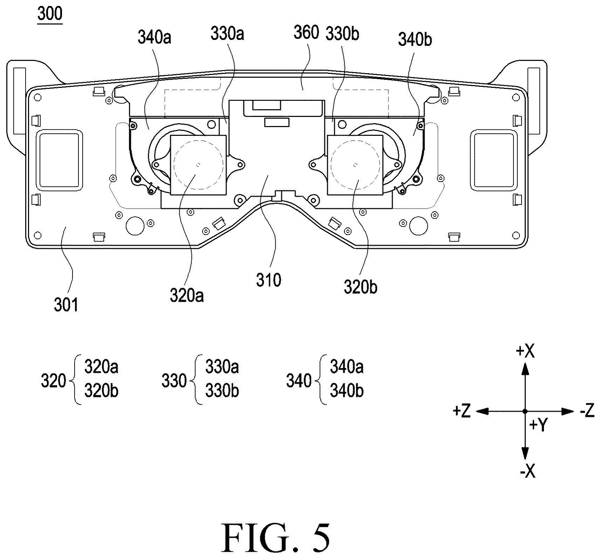

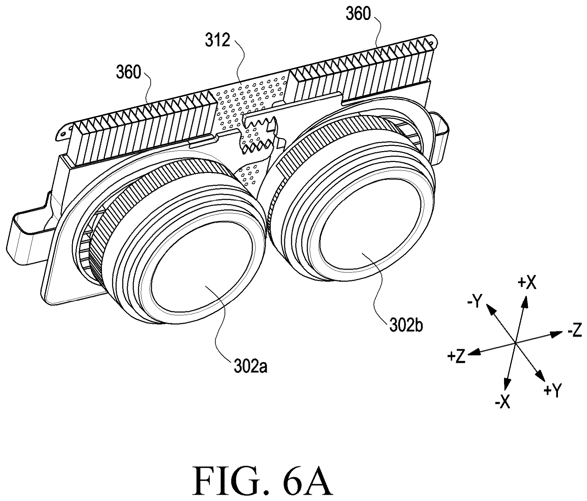

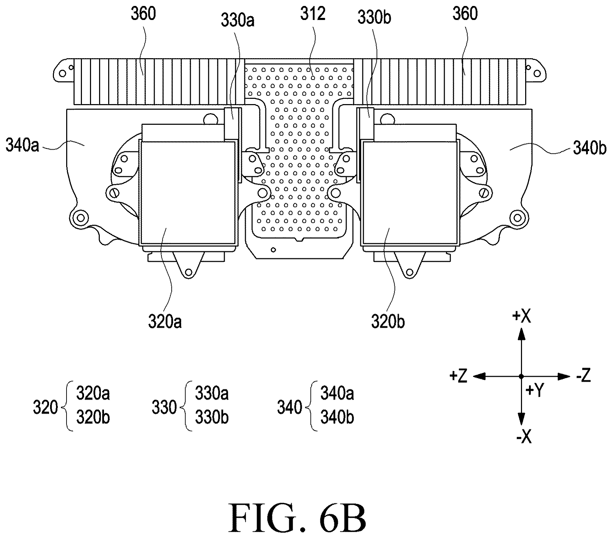

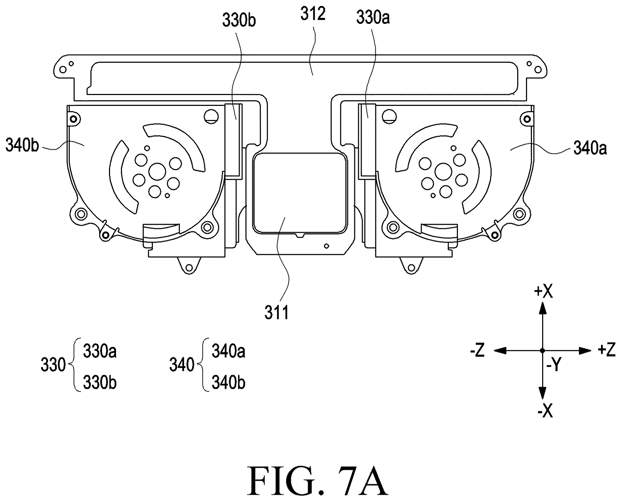

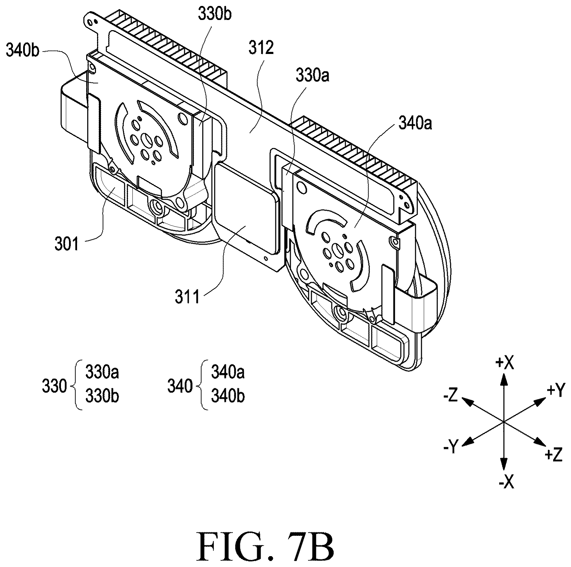

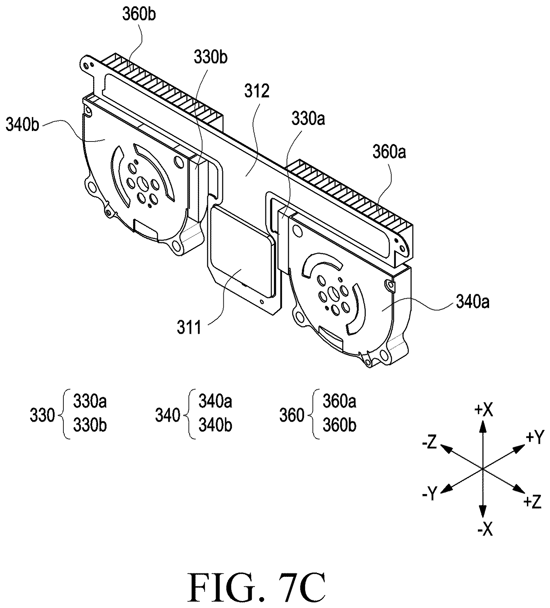

FIG. 5 is a view illustrating the inside of an electronic device 300 according to an embodiment disclosed herein. FIG. 6A is a perspective view illustrating some of the internal components of the electronic device 300 according to an embodiment disclosed herein. FIG. 6B is a rear view illustrating some of the internal components of the electronic device 300 according to an embodiment disclosed herein. FIGS. 7A, 7B, and 7C are perspective views illustrating some of the internal components of the electronic device 300 according to an embodiment disclosed herein.

Referring to FIGS. 5 to 7B, the electronic device 300 may include a housing 301, a printed circuit board 310, at least one display 320, at least one display plate 330, and at least one fan structure 340. Some or all of the components of the electronic device 300 of FIGS. 5 to 7B may be the same as those of the wearable electronic device 200 of FIGS. 2 to 4. The components in FIGS. 5 to 7B may be selectively combined with the components in FIGS. 2 to 4.

According to an embodiment, the electronic device 300 may be a wearable electronic device that is provided in a form that is wearable on a human body. Examples of wearable electronic devices include a head-mounted display device (e.g., a head-mounted device (HMD), smart glasses, a smart watch or wristband, a contact lens-type device, a ring-type device, a footwear-type device, a garment-type device, a glove-type device, and the like, and may have various forms capable of being detached from/attached to a part of a human body or clothes. The wearable electronic device is directly worn on a human body, so that portability and a user's accessibility can be improved. The wearable electronic device may be, for example, a head-mounted display device or head mounted device (HMD) that is mountable on, for example, a wearer's head or hear. Head-mounted displays or head mounted devices (HMDs) may be generally classified into a see-through type that provides augmented reality (AR) and a see-closed type that provides virtual reality (VR). The electronic device 300 according to an embodiment will be described limited to a head-mounted display device (HMD). However, the electronic device may be widely interpreted as other electronic devices.

According to an embodiment, a head-mounted display device (HMD) may be mounted on any portion of a human body, for example, the head, and may serve to display images. For example, the head-mounted display device may be configured in a shape of goggles or glasses. The head-mounted display device may have displays 320 configured to output an image located at a location facing the user's eyes, respectively.

According to an embodiment, the printed circuit board 310 may be equipped with a processor, memory, and/or an interface. The processor may include one or more of, for example, a central processing unit, an application processor, a graphics processing unit, an image signal processor, a sensor hub processor, or a communication processor. According to an embodiment, the printed circuit board 310 may include a flexible printed circuit board-type radio frequency cable (FRC). For example, the printed circuit board 310 may be electrically connected to an antenna module (e.g., the antenna module 197 in FIG. 1) and a communication module (e.g., the communication module 190 in FIG. 1).

According to an embodiment, the printed circuit board 310 including at least one heat source (e.g., the heat source 311 in FIGS. 7A to 7C) includes a flexible circuit board and/or a main circuit board connected to the displays 320. A plurality of electrical elements may be placed on the printed circuit board 310. Some of the plurality of electrical elements are heat sources 311 that generate heat, and may be one or more chips placed on the printed circuit board 310. For example, a display driver integrated circuit (DDI) may be placed on the flexible circuit board. As another example, at least one of a power management integrated circuit (PMIC), a power amplifier (PAM), an application processor (AP), a communication processor (CP), and a charger integrated circuit (IC) may be disposed on the main circuit board. Heat generated from at least one heat source 311 may cause malfunction and performance degradation of the electronic device.

According to an embodiment, the heat source 311 may be located in the center of the housing 301 with respect to the Z-axis. For example, with respect to the Z-axis, the heat source 311 may be located between a first display member 302a (e.g., the first display member 201a in FIG. 4) arranged to correspond to the user's left eye and a second display member 302b (e.g., the second display member 201b in FIG. 4) arranged to correspond to the user's right eye. For example, with respect to the Z-axis, the heat source 311 may be located between a first display 320a arranged to correspond the first display member 302a (e.g., the first display member 201a in FIG. 4) and a second display 320b arranged to correspond to the second display member 302b (e.g., the second display member 201b in FIG. 4) in which the first display member and the second display member will be described later. However, the location and arrangement of the heat source 311 are not limited to the above-described embodiment, and may be changed in various ways in design.

According to an embodiment, a heat dissipator 312 (e.g., a vapor chamber, a heat plate, a heat-spreader, or a metal shield can) may be disposed adjacent to the heat source 311. According to an embodiment, a heat dissipation member such as a heat pipe, a heat sink, a heat pin, a thermal pipe, or a thermal pin may be located in contact with the heat source 311 without a separate heat dissipator. The heat dissipator 312 may be a heat transfer structure configured to discharge and/or transfer heat from the heat source 311 to the outside of the electronic device 300. For example, the heat dissipator 312 may be a heat transfer structure configured to spread heat from the heat source 311 to other areas of the electronic device 300. For example, the heat dissipator 312 may be a heat transfer structure configured to spread heat from the heat source 311 to the heat sink 360 of the electronic device 300. The heat dissipator 312 may be made of a metal material with a high thermal conductivity, such as aluminum, iron, copper, or an alloy thereof. According to an embodiment, the heat dissipator 312 may be T-shaped. For example, the heat source 311 may be disposed on the heat dissipator 312, and the heat dissipator 312 may include a first portion (not illustrated) extending upward (e.g., the +X-axis direction) from the portion on which the heat source 311 is disposed, and a second portion extending from the upper ends of the first portion in a left direction (e.g., the +Z-axis direction in FIG. 5) and a right direction perpendicular to the first direction (e.g., the -Z-axis direction in FIG. 5). The first portion (not illustrated) may be located between the first display 320a and the second display 320b. The second portion (not illustrated) may be connected to the heat sink 360 located on the upper side of the electronic device 300 (e.g., in the +X-axis direction in FIG. 5). According to an embodiment, the heat dissipator 312 may include at least one hole (not illustrated) so as to inject heat dissipation gel.

According to an embodiment, a thermal interface material (TIM) (not illustrated) may be located between the heat source 311 and the heat dissipator 312. The heat interface material (not illustrated) may be designed to function while being pressed between the heat source 311 and the heat dissipator 312 by compression pressure. Heat generated from the heat source 311 may be transferred to the heat dissipator 312 via the heat interface material (not illustrated). The heat interface material (not illustrated) may include, for example, one of solder, polymer, polymer gel, polymer/solder hybrid, heat conductive sheet, or grease. In an embodiment, the thermal interface material (TIM) (not illustrated) may be omitted from the electronic device 300, or one or more other components may be added to the electronic device 300.

According to an embodiment, the heat sink 360 serves to quickly dissipate heat generated within the electronic device 300 to the outside of the electronic device 300. For example, the heat sink 360 serves to dissipate heat generated from the heat source 311 inside the electronic device 300 and/or the display 320 to the outside. According to an embodiment, the heat sink 360 may be located on the upper side of the electronic device 300 (e.g., in the +X-axis direction in FIG. 5). For example, the heat sink may be located on the upper side of the fan structure 340 of the electronic device 300 (e.g., in the +X-axis direction in FIG. 5). For example, the heat sink may be located on the upper side of the display members (e.g., the first display member 302a and the second display member 302b in FIG. 6A) of the electronic device 300 (e.g., in the +X-axis direction in FIG. 5). According to an embodiment, the heat sink 360 may be connected to the heat dissipator 312. For example, the heat sink may be connected to a second portion (not illustrated) of the heat dissipator 312 and may extend in the Z-axis direction to correspond to the second portion (not illustrated) of the heat dissipator 312. For example, the heat sink 360 may include a first heat sink 360a disposed on the upper side of the first display member 302a (e.g., in the +X-axis direction in FIG. 7C), and a second heat sink 360b disposed on the upper side of the second display member 302b (e.g., in the +X-axis direction in FIG. 7C). According to an embodiment, the heat sink 360 may be made of one selected from aluminum, copper, and their equivalents, but is not limited thereto.

According to an embodiment, the display 320 may provide information provided about an object or environment to a user in a visual form through a display member (e.g., the first display member 302a and the second display member 302b). According to an embodiment, the display 320 may include a first display 320a arranged to correspond to the user's left eye, and a second display 320b arranged to correspond to the user's right eye. According to an embodiment, in the case of a head-mounted display device (HMD), as a 4K display with high power consumption is used, a heat dissipation structure, which is capable of efficiently dissipating heat not only from the heat source 311 (e.g., an AP) but also from the display 320, may be required.

According to an embodiment, the display plate 330 may be configured to fix the position of the display 320. According to an embodiment, the display 320 may include a first display plate 330a arranged to correspond to the user's left eye and in contact with the first display 320a, and a second display plate 330b arranged to correspond to the user's right eye and in contact with the second display 320b. For example, the display plate 330 may be made of a metal material such as aluminum, iron, copper, or an alloy thereof. The electronic device 300 according to an embodiment is capable of efficiently dissipating heat from the display 320 by using the display plate 330 as a heat dissipation structure for dissipating the heat from the display 320.

According to an embodiment, the fan structure 340 may be configured to induce convection such that heat generated inside the electronic device 300 can be discharged to the outside of the electronic device 300. For example, the fan structure 340 may be configured to induce convection toward the upper side where the heat sink 360 is disposed (e.g., the +X-axis direction in FIG. 5) such that the heat generated from the heat source 311 inside of the electronic device and the display 320 can be discharged to the outside of the electronic device via the heat sink 360. According to an embodiment, the fan structure 340 may include a first fan structure 340a arranged to correspond to the user's left eye and in contact with the first display plate 330a, and a second fan structure 340b arranged to correspond to the user's right eye and in contact with the second display plate 330b. According to an embodiment, the fan structure 340 may include a plurality of outlets not only to reduce the temperature of the main heat source 311 (e.g., an AP), but also to remove the heat generated by the display 320. This will be described later.

According to an embodiment, an inlet vent hole (not illustrated) through which external air enters the inside of the electronic device may be located on one surface located at the lower end of the electronic device (the surface oriented in the -X-axis direction). According to an embodiment, an outlet vent hole (not illustrated) through which air inside the electronic device escapes to the outside may be located on one surface located at the upper end of the electronic device (the surface oriented in the +X-axis direction). For example, air may flow through the inlet vent hole (not illustrated), through which the air enters the inside of the electronic device, and the outlet vent hole (not illustrated), through which the air escapes to the outside, so that the air can circulate.

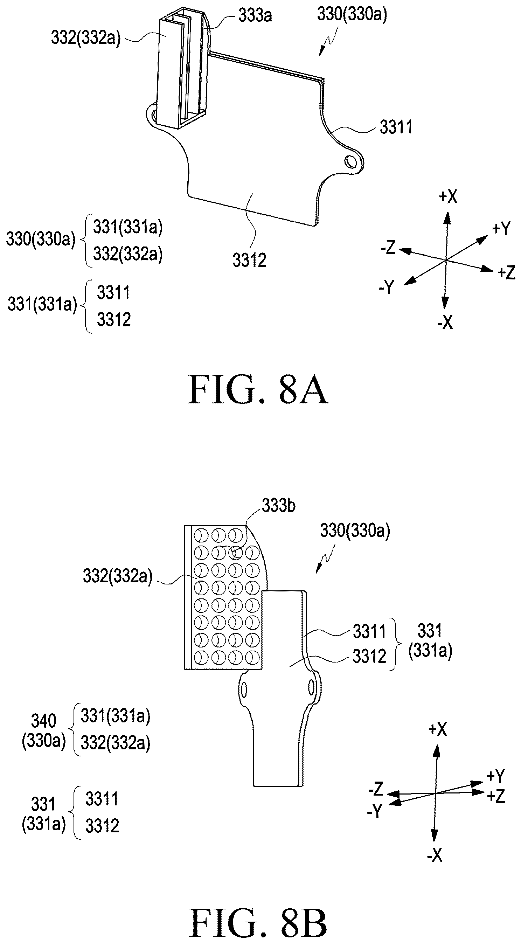

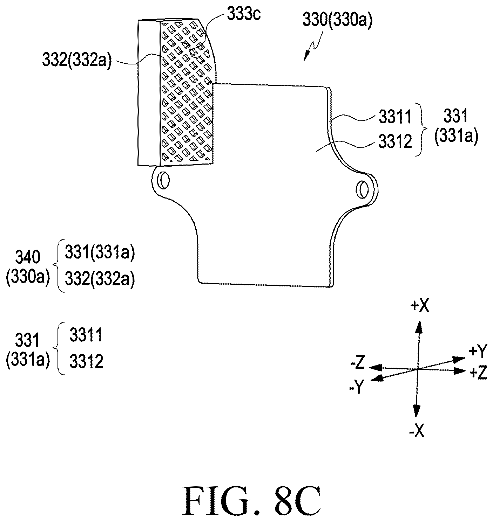

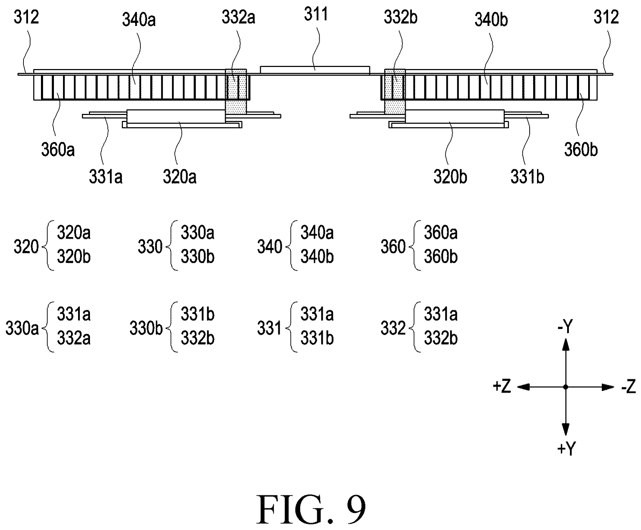

FIGS. 8A, 8B, and 8C are views illustrating a display plate 330 according to an embodiment disclosed herein. FIG. 9 is a side view illustrating some of the internal components of the electronic device 300 according to an embodiment disclosed herein, viewed in the X-axis direction.

Referring to FIGS. 8A to 9, an electronic device (e.g., the electronic device 300 in FIG. 5) may include at least one display plate 330. The components of the display plate 330 in FIGS. 8A to 9 may be the same as all or some of the components of the display plate 330 in FIGS. 5 to 7C. The components in FIGS. 8A to 9 may be selectively combined with the components in FIGS. 5 to 7C.

According to an embodiment, the display plate 330 may include a support member 331 and a protrusion member 332 substantially perpendicularly connected to the support member 331. According to an embodiment, the first display plate 330a, which is arranged to correspond to the user's left eye and is in contact with the first display 320a, may include a support member 331a and a protrusion member 332a substantially perpendicularly connected to the support member 331a (see FIG. 8A). According to an embodiment, the second display plate 330b, which is arranged to correspond to the user's right eye and is in contact with the second display 320b, may include a support member 331b and a protrusion member 332b substantially perpendicularly connected to the support member 331b.

According to an embodiment, the support member 331 of the display plate 330 may include a first surface 3311 facing one surface of the display 320 and oriented in a first direction (e.g., the rearward direction (the +Y-axis direction in FIG. 9), and a second surface 3312 facing one surface of the fan structure 340 and oriented in a second direction opposite to the first surface 3311 (e.g., the forward direction (the -Y-axis direction in FIG. 9)). According to an embodiment, the support member 331 of the display plate 330 may substantially correspond to the display 320 in size and/or shape.

According to an embodiment, the protrusion member 332 of the display plate 330 may extend in a second direction which is substantially a vertical direction from the edge of the second surface 3312 of the support member 331 (e.g., the forward direction (the -Y-axis direction in FIG. 9)). The protrusion member 332 of the display plate 330 may be connected to the fan structure 340. The protrusion member 332 of the display plate 330 may be in contact with a portion of the fan structure 340.

According to an embodiment, referring to FIG. 8A, the protrusion member 332 of the display plate 330 may include multiple bars 333a which extend vertically from the protrusion member 332 and are arranged at regular intervals to support the smooth flow of air. Since the multiple bars 333a are arranged in the vertical direction from the protrusion member 332, empty spaces may be formed in the Z-axis direction. Heat generated from the display 320 may be efficiently transferred to the outside through the empty spaces formed between the multiple bars 333a following the air flow generated by the fan structure 340. Instead of the multiple bars 333a, terms such as a bracket, a support member, or an air circulation member may also be used.

According to an embodiment, referring to FIGS. 8B and 8C, the protrusion member 332 of the display plate 330 may include multiple holes 333b and 333c. For example, referring to FIG. 8B, the multiple holes 333b may be circular. For example, multiple circular holes 333b may be arranged at predetermined intervals. For example, referring to FIG. 8C, the multiple holes 333b may have a diamond shape. For example, the multiple diamond-shaped holes 333c may be arranged at predetermined intervals. Heat generated from the display 320 may be efficiently transferred to the outside following the flow of air generated by the fan structure 340 through the multiple holes 333b and 333c. However, the shape of the display plate 330 and/or the structure formed for heat transfer in the protrusion member 332 is not limited to the above embodiment, and a design change may be made in various ways to increase an air contact area such that heat dissipation performance can be maximized depending on the air flow in the fan structure 340.

The electronic device according to an embodiment is capable of efficiently dissipating heat from the display 320 by using the display plate 330 as a heat dissipation structure for dissipating the heat from the display 320. For example, the protrusion member 332 of the display plate 330 may be coupled to the fan structure 340 to allow the heat generated from the display 320 to be transferred to the fan structure 340 via the display plate 330.

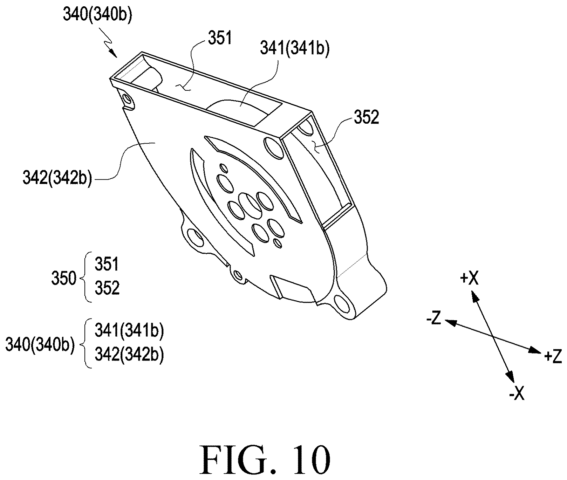

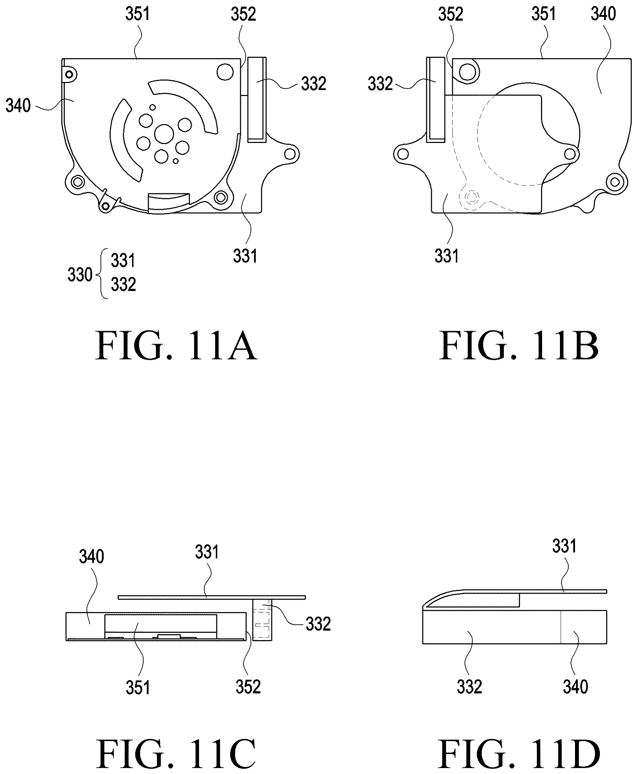

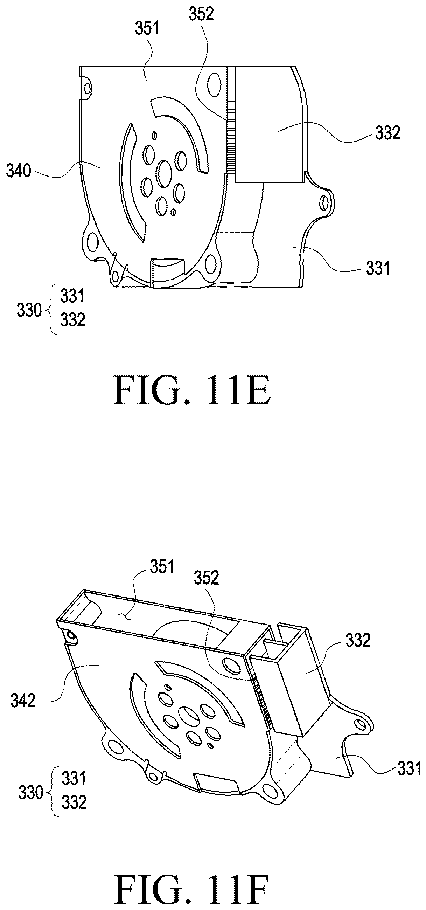

FIG. 10 is a view illustrating a fan structure 340 according to an embodiment disclosed herein. FIGS. 11A to 11F are views illustrating the coupling relationship between the fan structure 340 and the display plate 330 according to an embodiment disclosed herein.

Referring to FIGS. 10 to 11F, an electronic device (e.g., the electronic device 300 in FIG. 5) may include at least one display plate 330 and at least one fan structure 340. The components of the display plate 330 and the fan structure 340 in FIGS. 10 to 11F may be the same as all or some of the components of the display plate 330 and the fan structure 340 in FIGS. 5 to 9. The components of FIGS. 10 to 11F may be selectively combined with the components of FIGS. 5 to 9.

According to an embodiment, the fan structure 340 may include a fan 341 and a fan cover member 342 that covers the fan 341. For example, the first fan structure 340a may include a first fan (not illustrated) and a first fan cover member (not illustrated) that covers the first fan (not illustrated). For example, the second fan structure 340b may include a second fan 341b and a second fan cover member 342b that covers the second fan 341b. The fan structure illustrated in FIGS. 10 to 11F is the second fan structure 340b, but may be applied to the first fan structure 340a.

According to an embodiment, the fan cover member 342 of the fan structure 340 may include a first surface, a second surface oriented in an opposite direction to the first surface, and a third surface which is a side surface disposed substantially perpendicular to the first surface and the second surface. The first surface of the fan cover member 342 may face one surface of the support member 331 of the display plate 330. At least a portion of the third surface of the fan cover member 342 may be in contact with the protrusion member 332 of the display plate 330.

According to an embodiment, the fan cover member 342 of the fan structure 340 may include multiple outlets 350. The multiple outlets 350 may be provided in the fan cover member 342 of the fan structure 340. The multiple outlets 350 may be openings provided in the third surface which is a side surface of the fan cover member 342. The multiple outlets 350 may include a first outlet 351 with an opening formed in the upward direction of the electronic device (e.g., the +X-axis direction in FIG. 10) and a second outlet 352 with an opening formed in a lateral direction of the electronic device (e.g., the Z-axis direction in FIG. 10). For example, the second outlet 352 formed in the first fan structure 340b may be disposed on the right side surface of the third surface of the electronic device 300 (e.g., in the +Z-axis direction in FIG. 10). For example, the second outlet 352 may be disposed in the upper portion of one side surface of the third surface of the electronic device 300 (e.g., in the +X-axis direction in FIG. 10) in order to transfer heat in the upward direction (the +X-axis direction in FIG. 10). The first outlet 351 may be arranged substantially perpendicularly to the second outlet 352. According to an embodiment, the first outlet 351 and/or the second outlet 352 may have a square shape. However, the first outlet 351 and/or the second outlet 352 are not limited to the above embodiment and may be designed in various shapes such as circular.

According to an embodiment, among the multiple outlets 350, the first outlet 351 may be disposed adjacent to the printed circuit board 310 and configured to dissipate heat generated from the heat source 311 disposed on the printed circuit board 310. For example, the heat generated from the heat source 311 may be transferred to the upper side of the electronic device via the heat dissipator 312, and the heat flow may be effectively moved upward through the first outlet 351, which is an opening provided on the upper side, so that the heat can be efficiently dissipated by the heat sink 360 disposed on the upper side.

According to an embodiment, among the multiple outlets 350, the second outlet 352 may be coupled to the display plate 330, and the heat generated from the display 320 may be transferred to the display plate 330. The heat transferred to the display plate 330 may change its flow direction to the central portion of the electronic device 300 through the second outlet 352, which is an opening provided on a side surface and directed to the central portion of the electronic device 300. The heat moved to the central portion of the electronic device 300 can be efficiently dissipated along with the heat generated from the heat source 311 to the heat sink 360 disposed on the upper side.

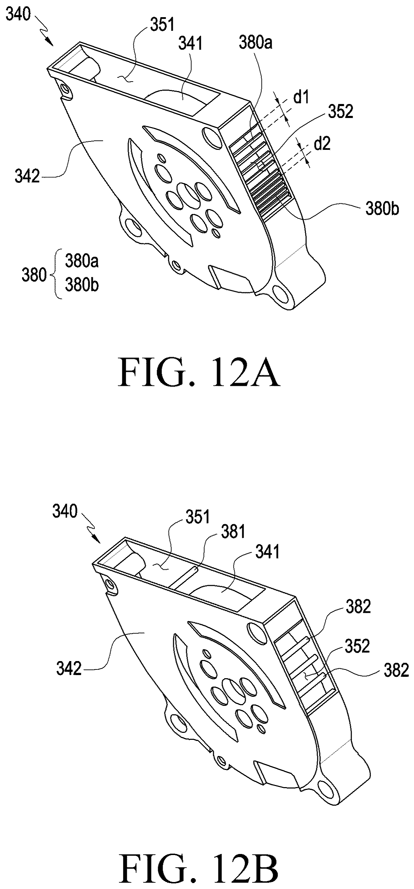

FIGS. 12A to 12C are views illustrating a fan structure 340 including multiple pillars according to an embodiment disclosed herein.

Referring to FIGS. 12A to 12C, an electronic device (e.g., the electronic device 300 in FIG. 5) may include at least one display plate 330 and at least one fan structure 340. The components of the display plate 330 and the fan structure 340 in FIGS. 12A to 12C may be the same as all or some of the components of the display plate 330 and the fan structure 340 in FIGS. 5 to 11F. The components in FIGS. 12A to 12C may be selectively combined with the components in FIGS. 5 to 11F.

According to an embodiment, the multiple outlets 350 of the fan structure 340 may include at least one pillar 380 to improve the rigidity of the fan cover member 342. The fan structure 340 may include at least one pillar 380 disposed at a location where the multiple outlets 350 are provided. According to an embodiment, the multiple outlets 350 of the fan structure 340 may include multiple pillars 380 arranged in consideration of performance and attenuation of noise generated during fan driving. The multiple pillars 380 may be configured to vertically connect the first and second surfaces of the fan cover member in the empty space of the first outlet 351 and/or the second outlet 352. The multiple pillars 380 are capable of reducing noise by preventing eddy currents caused by movement of air generated by fan driving. Instead of the multiple pillars 380, terms such as multiple poles, multiple columns, and multiple supports may be used.

According to an embodiment, referring to FIG. 12A, the second outlet 352 may include the multiple pillars 380 at different intervals. For example, the distance between the multiple pillars 380 may become narrower toward the lower side of the second outlet 352 (e.g., in the -X-axis direction in FIG. 5). For example, the second outlet 352 may include multiple first pillars 380a arranged at a first interval d1, and multiple second pillars 380b arranged at a second interval d2 narrower than the first interval d1 and located under the multiple first pillars. This is to prevent a phenomenon in which eddy currents are formed and wind sound increases to generate and increase noise when air moves to the lower side of the second outlet 352, and to cause air to flow toward the upper side (e.g., in the +X-axis direction in FIG. 5).

According to an embodiment, referring to FIG. 12B, the first outlet 351 may include at least one third pillar 381, and the second outlet 352 may include at least one fourth pillar 382. For example, the first outlet 351 may include one third pillar 381, and the second outlet 352 may include multiple fourth pillars 382 arranged at intervals narrower than the first outlet 351. For example, the first outlet 351 may include one third pillar 381, and the second outlet 352 may include three fourth pillars 382. However, the presence or absence of pillars and the intervals between the multiple pillars are not limited to the above embodiment, and a design change may be made in various ways depending on heat dissipation performance and noise.

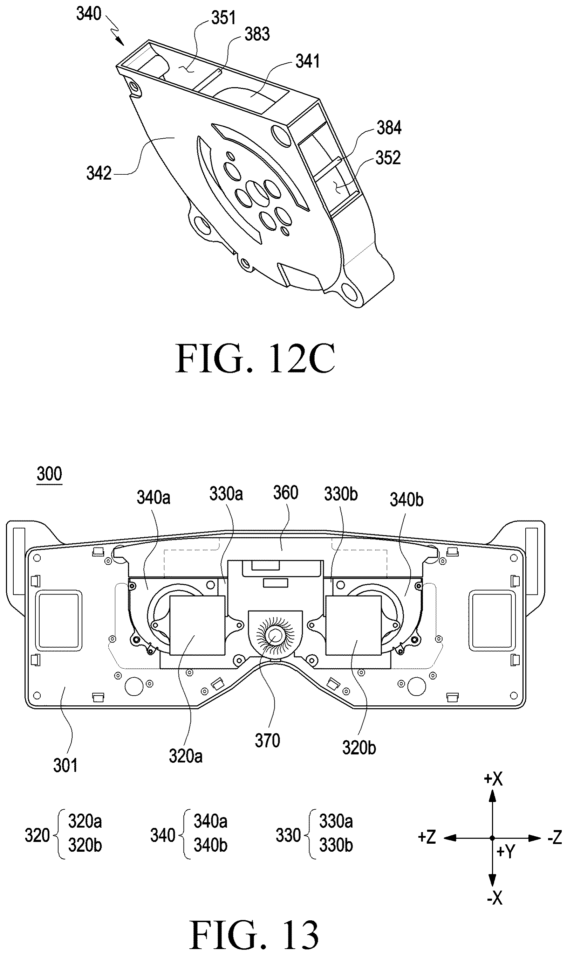

According to an embodiment, referring to FIG. 12C, the first outlet 351 may include at least one fifth pillar 383, and the second outlet 352 may include at least one sixth pillar 384. For example, the first outlet 351 may include one fifth pillar 383, and the second outlet 352 may include one sixth pillar 384. However, the presence or absence of pillars and the intervals between the multiple pillars are not limited to the above embodiment, and a design change may be made in various ways depending on heat dissipation performance and noise.

FIG. 13 is a view illustrating an electronic device 300 including a small fan structure 370 according to an embodiment disclosed herein.

Referring to FIG. 13, the electronic device 300 may include a housing 301, a printed circuit board 310, at least one display 320, at least one display plate 330, at least one fan structure 340, and at least one small fan structure 370. Some or all of the components of the electronic device 300 of FIG. 13 may be the same as those of the wearable electronic device 200 in FIGS. 2 to 4. The components in FIG. 13 may be selectively combined with the components in FIGS. 2 to 4.

According to an embodiment, the small fan structure 370 may be located in the central portion of the electronic device 300 and guide the flow of heat generated in the display 320 upward. According to an embodiment, the small fan structure 370 may be located in the central portion of the electronic device and guide the flow of heat generated in the display 320 upward (e.g., in the +X-axis direction in FIG. 5) to be transferred to the heat sink 360.

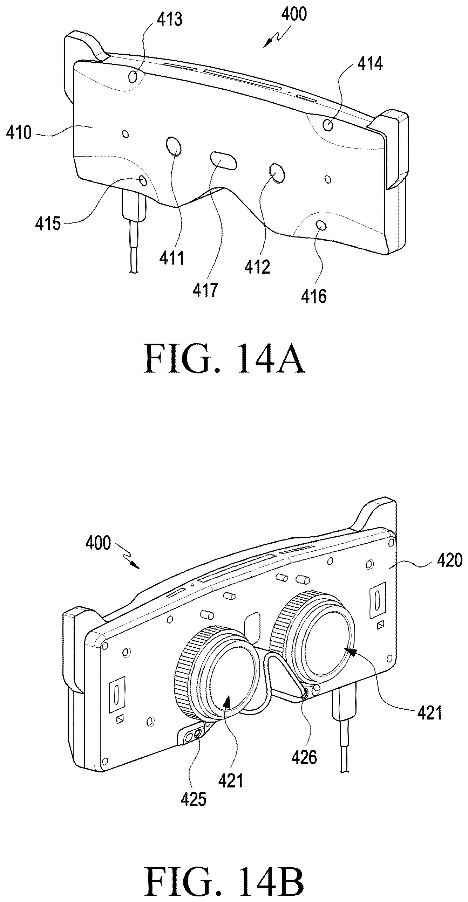

FIG. 14A is a view illustrating the front side of a wearable electronic device according to an embodiment of the disclosure. FIG. 14B is a view illustrating the rear side of a wearable electronic device according to an embodiment of the disclosure.

The components of the wearable electronic device 400 of FIGS. 14A and 14B may be the same as all or some of the components of the wearable electronic device 200 in FIGS. 2 to 4 and the components of the electronic device 300 of FIGS. 5 to 13. The components in FIGS. 14A and 14B may be selectively combined with the components in FIGS. 2 to 13.

In an embodiment, the wearable electronic device 400 may be AR glasses or video see-through (VST)-type VR glasses. In an embodiment, the VST-type VR glasses may capture an image of an external environment by using a camera (not illustrated) and display the captured image of the external environment along with VR content to a user through a display. For example, the VR content may be content such as data related to navigation or a specific object.

Referring to FIGS. 14A and 14B, in an embodiment, camera modules 411, 412, 413, 414, 415, and 416 and/or a depth sensor 417 configured to acquire information related to the surrounding environment of the wearable electronic device 400 may be arranged on the first surface 410 of the housing.

In an embodiment, the camera modules 411 and 412 may acquire images related to the surrounding environment of the wearable electronic device.

In an embodiment, the camera modules 413, 414, 415, and 416 may acquire images while the wearable electronic device 400 is worn by the user. The camera modules 413, 414, 415, and 416 may be used for hand detection and tracking, or user gesture (e.g., hand motion) recognition. The camera modules 413, 414, 415, and 416 may be used for 3 degrees of freedom (3DoF) or 6DoF head tracking, location (space, environment) recognition, and/or movement recognition. In an embodiment, camera modules 411 and 412 may be used for hand detection and tracking, and user gesture recognition.

In an embodiment, the depth sensor 417 may be configured to transmit a signal and receive a signal reflected from a subject, and may be used to identify the distance to an object, such as time of flight (TOF). Instead of or in addition to the depth sensor 217, the camera modules 213, 214, 215, and 216 may identify the distance to an object.

According to an embodiment, the camera modules 425 and 426 and/or the display 421 (and/or lenses) for face recognition may be disposed on the second surface 420 of the housing.

In an embodiment, the face recognition camera modules 425 and 426 located adjacent to the display may be used to recognize the user's face, or may recognize and/or track both of the user's eyes.

In an embodiment, the display 421 (and/or lenses) may be disposed on the second surface 420 of the wearable electronic device 400. In an embodiment, among the plurality of camera modules 413, 414, 415, and 416, the wearable electronic device 400 may not include some camera modules 415 and 416. At least one of the components illustrated in FIGS. 14A and 14B may be omitted from the wearable electronic device 400, or the electronic device 400 may further include components not illustrated in the drawings. For example, at least one of the above-mentioned camera modules may be omitted from the wearable electronic device 400, or the electronic device 400 may include a greater number of camera modules.

As described above, the wearable electronic device 400 according to an embodiment may have a form factor to be worn on a user's head. The wearable electronic device 400 may further include a strap and/or a wearing member to be fixed on a portion of a user's body. The wearable electronic device 400 may provide a user experience based on augmented reality, virtual reality, and/or mixed reality while worn on the user's head.

In general, in order to increase the heat dissipation performance of an electronic device, a fan 341 is applied within the electronic device, but the fan may be designed mainly to dissipate heat from the main heat source 311 (e.g., an AP). In the case of a head-mounted display device (HMD), since a display 320 consumes high power, a heat dissipation structure may be needed to efficiently dissipate heat of the display 320. In general, it may be structurally difficult to connect both the main heat source 311 (e.g., an AP) and the display 320 to a single heat sink 360, and an outlet of a fan 341 that emits wind in one direction may have limitations as a structure for dissipating heat from the main heat source 311 (e.g., an AP) and the display 320.

According to an embodiment, it is possible to provide an electronic device equipped with a heat dissipation device capable of efficiently dissipating heat generated when the electronic device is driven and heat generated by the operation of a display 320.

According to an embodiment, it is possible to provide an electronic device including a fan structure 340 including multiple outlets 350 to efficiently dissipate heat generated from a main heat source 311 (e.g., an AP) and a display 320.

According to an embodiment, it is possible to provide an electronic device in which a display plate 330 configured to fix a display 320 is connected to a fan structure 340 to efficiently dissipate heat generated from a main heat source 311 (e.g., an AP) and a display 320.

An electronic device according to an embodiment is capable of efficiently dissipating heat from a display 320 by using a display plate 330 as a heat dissipation structure for dissipating the heat from the display 320. For example, a protrusion member 332 of the display plate 330 may be coupled to a fan structure 340 to allow the heat generated from the display 320 to be transferred to the fan structure 340 via the display plate 330.

The technical problems to be addressed by this disclosure are not limited to those described above, and other technical problems, which are not described above, will be clearly understood by a person ordinarily skilled in the related art to which the disclosure belongs from the following description.

A head-mounted display device according to an embodiment of the disclosure may include a housing 301, a printed circuit board 310 located inside the housing and including a heat source, at least one display 320 located inside the housing, at least one display plate 330 configured to support the display, and at least one fan structure 340 comprising a fan and multiple outlets and configured to guide heat generated inside the head-mounted display device to be discharged to the outside of the head-mounted display device. The multiple outlets may include a first outlet disposed adjacent to the printed circuit board and configured to dissipate heat generated from the heat source, and a second outlet disposed in contact with a portion of the display plate and configured to dissipate heat generated from the display and transferred to the display plate.

According to an embodiment, the display plate may include a support member 331, and a protrusion member 332 vertically connected to the support member.

According to an embodiment, the support member may include a first surface 3311 facing one surface of the display and oriented in a first direction, and a second surface 3312 facing one surface of the fan structure and oriented in a second direction opposite to the first direction where the first surface is arranged, and the protrusion member may extend from an edge of the second surface of the support member in the second direction.

According to an embodiment, the protrusion member may further include multiple bars 333a extending vertically from the protrusion member and spaced apart from each other at regular intervals.

According to an embodiment, the protrusion member may further include multiple holes 333b.

According to an embodiment, the fan structure may include a fan 341 and a fan cover member 342 which covers the fan, and the fan cover member may include the multiple outlets.

According to an embodiment, the second outlet in the fan structure and the protrusion member of the display plate may be in contact with each other.

According to an embodiment, the head-mounted display device may further include a heat dissipator 312 comprising a heat dissipating material and disposed adjacent to the heat source and configured to transfer heat from the heat source 311 to the inside of the head-mounted display device 300.

According to an embodiment, the heat sink may be T-shaped.

According to an embodiment, the multiple outlets 350 may include at least one pillar 380.

According to an embodiment, the second outlet may include multiple first pillars 380a arranged at a first interval d1, and multiple second pillars 380b arranged at a second interval d2 narrower than the first interval d1 and located under the multiple first pillars.

An electronic device according to an embodiment of the disclosure may include a housing, a printed circuit board located inside the housing and including a heat source, at least one display located inside the housing, at least one display plate configured to support the display, and at least one fan structure comprising a fan and multiple outlets and configured to induce convection so that heat generated inside the electronic device can be discharged to the outside of the electronic device. The multiple outlets may include a first outlet disposed adjacent to the printed circuit board and configured to dissipate heat generated from the heat source, and a second outlet disposed in contact with a portion of the display plate and configured to dissipate heat generated from the display and transferred to the display plate. The multiple outlets 350 may include at least one pillar 380.

According to an embodiment, the display plate may include a support member 331, and a protrusion member 332 vertically connected to the support member.

According to an embodiment, the support member may include a first surface 3311 facing one surface of the display and oriented in a first direction, and a second surface 3312 facing one surface of the fan structure and oriented in a second direction opposite to the first direction where the first surface is arranged, and the protrusion member may extend from an edge of the second surface of the support member in the second direction.

According to an embodiment, the protrusion member may further include multiple bars 333a extending vertically from the protrusion member and spaced apart from each other at regular intervals.

According to an embodiment, the protrusion member may further include multiple holes 333b.

According to an embodiment, the fan structure may include a fan 341 and a fan cover member 342 which covers the fan, and the fan cover member may include the multiple outlets.

According to an embodiment, the second outlet in the fan structure and the protrusion member of the display plate may be in contact with each other.

According to an embodiment, the head-mounted display device may further include a heat dissipator 312 disposed adjacent to the heat source and configured to transfer heat from the heat source 311 to the inside of the electronic device 300.

According to an embodiment, the heat sink may be T-shaped.

The effects that are capable of being obtained by the disclosure are not limited to those described above, and other effects not described above may be clearly understood by a person ordinarily skilled in the art to which the disclosure belongs based on the following description. While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. A head-mounted display device (300) comprising:
a housing (301);
a printed circuit board (310) disposed inside the housing and comprising at least one heat source;
at least one display (320) disposed inside the housing;
at least one display plate (330) configured to support the display; and
at least one fan structure (340) configured to guide heat generated inside the head-mounted display device to be discharged outside of the head-mounted display device, the at least one fan structure including a fan and multiple outlets,
wherein the multiple outlets comprise:
a first outlet disposed adjacent to the printed circuit board and configured to dissipate heat generated from the heat source; and
a second outlet disposed in contact with a portion of the display plate and configured to dissipate heat generated from the display and transferred to the display plate.

2. The head-mounted display device of claim 1, wherein the display plate comprises a support member (331), and a protrusion member (332) vertically connected to the support member and facing the second outlet.

3. The head-mounted display device of claim 2, wherein the support member comprises a first surface (3311) facing one surface of the display and oriented in a first direction where the display is positioned, and a second surface (3312) facing one surface of the fan structure and oriented in a second direction opposite to the first direction, and
wherein the protrusion member extends from an edge of the second surface of the support member in the second direction.

4. The head-mounted display device of claim 2, wherein the protrusion member further comprises multiple bars (333a) extending vertically from a portion of the protrusion member and spaced apart from each other at regular intervals.

5. The head-mounted display device of claim 2, wherein the protrusion member further comprises multiple holes (333b).

6. The head-mounted display device of one of claims 1 to 5, wherein the fan structure comprises a fan (341) and a fan cover member (342) which covers the fan and comprises the multiple outlets.

7. The head-mounted display device of one of claims 2 to 5, wherein the second outlet in the fan structure is disposed to contact with the protrusion member of the display plate.

8. The head-mounted display device of one of claims 1 to 7, further comprising a heat dissipator (312) comprising a heat dissipating material and disposed adjacent to the heat source and configured to transfer heat from the heat source (311) to a location of the first outlet or the second outlet.

9. The head-mounted display device of claim 8, wherein the heat sink is disposed to at least partially contact with at least a portion of the first outlet.

10. The head-mounted display device of one of claims 1 to 9, wherein the multiple outlets (350) comprise at least one pillar (380).

11. The head-mounted display device of one of claims 1 to 10, wherein at least one of the first outlet and the second outlet comprises multiple first pillars (380a) disposed at a first interval (d1), and multiple second pillars (380b) disposed at a second interval (d2) narrower than the first interval (d1) and located under the multiple first pillars.

12. An electronic device comprising:
a housing (301);
a printed circuit board (310) disposed inside the housing and comprising at least one heat source;
at least one display (320) disposed inside the housing;
at least one display plate (330) configured to support the display; and
at least one fan structure (340) comprising multiple outlets and configured to induce convection so that heat generated inside the electronic device can be discharged outside of the electronic device, the at least one fan structure including a fan and multiple outlets,
wherein the multiple outlets comprise:
a first outlet disposed adjacent to the printed circuit board and configured to dissipate heat generated from the heat source; and
a second outlet disposed in contact with a portion of the display plate and configured to dissipate heat generated from the display and transferred to the display plate, and
wherein the multiple outlets (350) comprise at least one pillar (380).

13. The electronic device of claim 12, wherein the display plate comprises a support member (331), and a protrusion member (332) vertically connected to the support member.

14. The electronic device of claim 13, wherein the support member comprises a first surface (3311) facing one surface of the display and oriented in a first direction, and a second surface (3312) facing one surface of the fan structure and oriented in a second direction opposite to the first direction where the first surface is arranged, and
wherein the protrusion member extends from an edge of the second surface of the support member in the second direction.

15. The electronic device of claim 13, wherein the protrusion member further comprises multiple bars (333a) extending vertically from a portion of the protrusion member and spaced apart from each other at regular intervals.
